# EUROPÄISCHE PATENTSCHRIFT

(11) **EP 3 341 741 B1**
(45) Veröffentlichungstag und Bekanntmachung des Hinweises auf die Patenterteilung: **04.09.2019**
(21) Anmeldenummer: 16751517.0
(22) Anmeldetag: 26.07.2016
(51) Int. Cl.: G01R 3/00, G01R 1/067, G01R 1/073

(54) **VORRICHTUNG ZUR ENTFERNUNG EINES PRÜFKONTAKTS EINER PRÜFKONTAKTANORDNUNG**
DEVICE FOR REMOVING A TEST CONTACT OF A TEST CONTACT ARRANGEMENT
DISPOSITIF POUR RETIRER UN CONTACT DE TEST D'UN ENSEMBLE DE CONTACTS DE TEST

(30) Priorität: 26.08.2015 DE 102015114129
(43) Veröffentlichungstag der Anmeldung: 04.07.2018
(73) Patentinhaber: Pac Tech - Packaging Technologies GmbH, 14641 Nauen (DE)
(72) Erfinder: KRAUSE, Thorsten, 16727 Velten (DE); AZDASHT, Ghassem, 13591 Berlin (DE)
(74) Vertreter: advotec.
(86) Internationale Anmeldenummer: PCT/EP2016/067761
(87) Internationale Veröffentlichungsnummer: WO 2017/032532

(56) Entgegenhaltungen:
- DE-A1-102008 051 853
- US-A1- 2002 060 580
- US-A1- 2004 060 971

## Beschreibung

Die vorliegende Erfindung betrifft eine Vorrichtung zur Platzierung und Kontaktierung eines Prüfkontakts einer auf einem Kontaktträger angeordneten Prüfkontaktanordnung, wobei die Vorrichtung einen Kontaktkopf mit zumindest einem Transmissionskanal zur Transmission von Wärmeenergie und Übertragung von Unterdruck aufweist, wobei der Kontaktkopf an seinem Kontaktierungsende im Bereich einer Kanalmündung mit einer Prüfkontaktaufnahme versehen ist.

Aus der DE 10 2008 051 853 A1 ist eine Vorrichtung zur Platzierung und Kontaktierung von Prüfkontakten auf einem Kontaktträger bekannt, die zur Herstellung einer Prüfkontaktanordnung auf dem Kontaktträger dient. Zur Herstellung der Prüfkontaktanordnung werden einzelne Prüfkontakte einander nachfolgend mit geringem Abstand in einer Reihenanordnung auf dem Kontaktträger angeordnet. Unmittelbar nachfolgend der Platzierung des einzelnen Prüfkontakts mit einer Kontaktkante auf einem mit einem Lotdepot versehenen Anschlusskontakt des Kontaktträgers erfolgt eine Beaufschlagung des Prüfkontakts mit Wärmeenergie zur Herstellung einer Lotverbindung zwischen dem Prüfkontakt und dem Lotdepot.

Die aus der DE 10 2008 051 853 A1 bekannte Vorrichtung weist einen Kontaktkopf auf, der an seinem Kontaktierungsende eine Prüfkontaktaufnahme mit einer Prüfkontaktanlagefläche zur Positionierung des Prüfkontakts aufweist. Bei der bekannten Vorrichtung erfolgt die Einbringung der zum Aufschmelzen eines auf dem Kontaktträger angeordneten Lotdepots erforderlichen Wärmeenergie mittels einer direkten Beaufschlagung des Prüfkontakts mit Laserenergie. Hierzu wird eine im Bereich einer Kanalmündung exponierte Oberfläche des Prüfkontakts als Absorptionsfläche genutzt. In der DE 10 2008 051 853 A1 wird daher vorgeschlagen, den Prüfkontakt unter einem Neigungswinkel zur Kanalachse des Transmissionskanals anzuordnen, um eine möglichst große Absorptionsfläche und damit einen für eine sichere Kontaktierung ausreichenden Wärmeenergieeintrag zu ermöglichen.

Aufgrund einer entsprechenden Schrägstellung der Prüfkontaktaufnahme zur Kanalachse des Kontaktkopfs ist der bekannte Kontaktkopf ausschließlich für eine sequenzielle, also eine in einer Richtung kontinuierlich fortschreitende Platzierung und Kontaktierung der Prüfkontakte auf dem Kontaktträger ausgelegt. Eine vereinzelte Kontaktierung eines Prüfkontakts in beliebiger Reihenfolge ist mit dem bekannten Kontaktkopf nicht vorgesehen.

Im Betrieb der Prüfkontaktanordnung oder auch bei der Herstellung der Prüfkontaktanordnung kann es zu Beschädigungen oder Fehlkontaktierungen von Prüfkontakten kommen, die den Austausch einzelner Prüfkontakte an beliebiger Stelle der Prüfkontaktanordnung notwendig machen.

Aufgabe der Erfindung ist es daher, eine Vorrichtung der eingangs genannten Art vorzuschlagen, die eine vereinzelte Kontaktierung eines Prüfkontakts an beliebiger Stelle einer Prüfkontaktanordnung mit für eine sichere Kontaktierung ausreichendem Wärmeenergieeintrag ermöglicht.

Zur Lösung dieser Aufgabe weist die erfindungsgemäße Vorrichtung die Merkmale des Anspruchs 1 auf.

Erfindungsgemäß weist die Vorrichtung eine Prüfkontaktaufnahme mit einem zwischen zwei parallelen Aufnahmewangen zur Aufnahme des Prüfkontakts ausgebildeten und mit dem Transmissionskanal verbundenen Aufnahmespalt auf, wobei die Aufnahmewangen an ihren Kontaktenden Kontaktflächen zur Herstellung eines wärmeleitenden Kontakts mit einem auf dem Kontaktträger angeordneten Lotdepot aufweisen.

Aufgrund der Ausbildung der Prüfkontaktaufnahme mit einem zwischen zwei parallelen Aufnahmewangen ausgebildeten Aufnahmespalt und Aufnahmewangen, die an ihren Kontaktenden Kontaktflächen zur Herstellung eines wärmeleitenden Kontakts mit dem Lotdepot aufweisen, ist es zum einen möglich, den Prüfkontakt, der vereinzelt auf dem Kontaktträger platziert werden soll, in definierter Positionierung und durch Unterdruckbeaufschlagung in dieser Position gesichert der Verbindungsstelle auf dem Kontaktträger zuzuführen und mittels derselben Aufnahmewangen, die den Prüfkontakt positioniert halten, die zum Aufschmelzen des Lotmaterials erforderliche Wärmeenergie in das Lotdepot einzubringen, wobei hierzu eine Beaufschlagung der Aufnahmewangen mit Wärmeenergie im Bereich der Kanalmündung ausreichend ist.

Die Ausgestaltung der Prüfkontaktaufnahme mit parallelen Aufnahmewangen ermöglicht darüber hinaus eine Ausgestaltung der Prüfkontaktaufnahme mit möglichst geringer Breite, die das Einführen der Prüfkontaktaufnahme in einen durch eine Prüfkontaktfehlstelle zwischen benachbarten Prüfkontakten gebildeten Zwischenraum ermöglicht.

Obwohl die erfindungsgemäße Vorrichtung in erster Linie dazu gedacht ist, an vorhandenen Prüfkontaktfehlstellen zwischen benachbarten Prüfkontakten einer Prüfkontaktanordnung zum Schließen der Fehlstelle einen vereinzelten Prüfkontakt zwischen benachbarten Prüfkontakten zu platzieren und nachfolgend zu kontaktieren, ist es grundsätzlich auch möglich, die erfindungsgemäße Vorrichtung zur Entfernung eines Prüfkontakts, also zur Herstellung einer Fehlstelle zwischen zwei benachbarten Prüfkontakten, zu verwenden. Damit kann also beispielsweise eine Entfernung eines beschädigten Prüfkontakts durch eine Platzierung der Prüfkontaktaufnahme auf dem Kontaktträger derart erfolgen, dass der Aufnahmespalt über den Prüfkontakt geführt wird und die Kontaktenden der Aufnahmewangen mit ihren Kontaktflächen gegen das Lotdepot auf dem Kontaktträger kontaktiert werden und durch eine Beaufschlagung des Lotdepots mit Wärmeenergie über die Aufnahmewangen ein Aufschmelzen des Lotdepots erfolgt. Nach dem Aufschmelzen des Lotdepots kann durch Unterdruckbeaufschlagung des Prüfkontakts mit gleichzeitiger Entfernung des Kontaktkopfs von dem Kontaktträger eine Fehlstelle in der Prüfkontaktanordnung erzeugt werden, die nachfolgend mittels desselben Kontaktkopfs nach Austausch des im Aufnahmespalt angeordneten Prüfkontakts gegen einen neuen Prüfkontakt wieder mit einem neuen Prüfkontakt bestückt werden kann, wobei zur Herstellung einer Lotverbindung zwischen dem neuen Prüfkontakt und dem Lotdepot auf dem Kontaktträger wieder ein Aufschmelzen des Lotdepots mittels der Aufnahmewangen erfolgt.

Bei einer bevorzugten Ausführungsform der Vorrichtung weist der Transmissionskanal in der Kanalmündung im Übergang zu einem Öffnungsrand des Aufnahmespalts eine Absorptionsfläche in einer Kanalwandung auf, die einen größeren Neigungswinkel zu einer Kanalachse aufweist als ein an die Absorptionsfläche angrenzender Wandabschnitt der Kanalwandung, so dass die für den Wärmeeintrag maßgebliche Flächenprojektion senkrecht zur Kanalachse benachbart zum Öffnungsrand des Aufnahmespalts relativ vergrößert und somit der Wärmeeintrag verbessert wird.

Vorzugsweise ist die Absorptionsfläche durch einen Absatz in der Kanalwandung ausgebildet, wobei es besonders zu bevorzugen ist, wenn die Absorptionsfläche durch eine Parabolfläche ausgebildet ist, so dass im Falle der Beaufschlagung der Absorptionsfläche mit Strahlungsenergie im Bereich der Absorptionsfläche noch eine Strahlungskonzentration erfolgt.

Wenn die Aufnahmewangen aus einem vom Material der Kanalwandung abweichenden Material gebildet sind, kann beispielsweise für die Aufnahmewangen ein Material mit besonders hoher Wärmekapazität und für die Kanalwandung ein Material mit besonders geringer Wärmekapazität gewählt werden, um zum einen eine möglichst gute Wärmeübertragung zum Lotdepot zu ermöglichen und zum anderen einen unerwünschten Wärmeenergieabfluss über die Kanalwandung zu minimieren.

Zur Optimierung des Wärmeübergangs zwischen den Kontaktflächen der Aufnahmewangen und dem auf dem Kontaktträger angeordneten Lotdepot ist es vorteilhaft, wenn die Kontaktflächen ein Flächenprofil aufweisen, das der Topographie des Lotdepots angepasst sein kann.

Wenn die Aufnahmewangen austauschbar an der Prüfkontaktaufnahme angeordnet sind, kann je nach Anwendungsfall das jeweilig für die Zusammensetzung des Lotmaterials des Lotdepots am besten geeignete Material der Aufnahmewangen gewählt werden.

Besonders vorteilhaft ist es, wenn die Vorrichtung neben einer Anschlussvorrichtung zur Verbindung mit einer Lasereinrichtung und einer Anschlussvorrichtung zur Verbindung mit einer Unterdruckquelle eine Infrarot-Sensoreinrichtung aufweist mit einem Infrarotsensor zur Erfassung einer von den Aufnahmewangen reflektierten Infrarotstrahlung und mit einer Steuereinrichtung zur Steuerung der Lasereinrichtung in Abhängigkeit von einem Sensorsignal des Infrarotsensors.

Somit kann das Sensorsignal beispielsweise genutzt werden, um eine Temperaturbelastung der Aufnahmewangen zu begrenzen, derart, dass bei Erreichen einer definierten Temperatur der Aufnahmewangen die Lasereinrichtung deaktiviert wird.

Nachfolgend wird eine bevorzugte Ausführungsform der Erfindung anhand der Zeichnungen näher erläutert.

Es zeigen:
- **Fig. 1**: einen Kontaktkopf der Vorrichtung mit einem in der Prüfkontaktaufnahme aufgenommenen Prüfkontakt während eines Kontaktierungsvorgangs;
- **Fig. 2**: eine Längsschnittdarstellung des Kontaktkopfs;
- **Fig. 3**: eine vergrößerte Darstellung einer Prüfkontaktaufnahme des Kontaktkopfs.

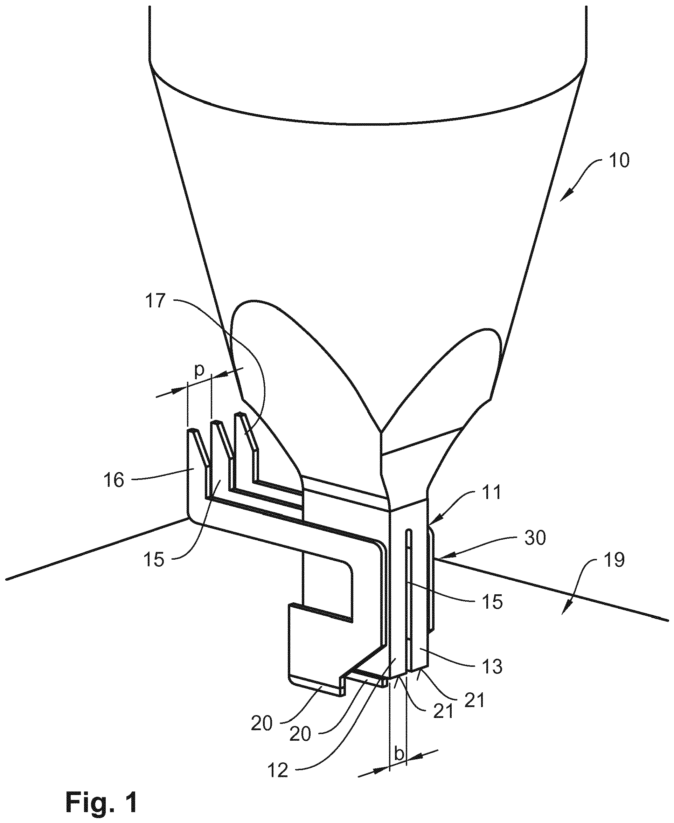

**Fig. 1** zeigt einen Kontaktkopf 10 mit einer Prüfkontaktaufnahme 11, die in einem zwischen zwei parallelen Aufnahmewangen 12, 13 ausgebildeten Aufnahmespalt 14 einen Prüfkontakt 15 während eines Kontaktierungsvorgangs aufnimmt.

Bei dem in **Fig. 1** dargestellten Anwendungsfall wird der Prüfkontakt 15 an einer Fehlstelle einer Prüfkontaktanordnung 30 zwischen benachbart der Fehlstelle angeordneten Prüfkontakten 16, 17 platziert. Dabei erfolgt mittels des Kontaktkopfs 10 eine zu den benachbarten Prüfkontakten 16, 17 parallele Ausrichtung des Prüfkontakts 15, wobei der Prüfkontakt 15 mit einer Kontaktkante 18 auf einem auf einem Kontaktträger 19 angeordneten Lotdepot 20 positioniert wird und nachfolgend über einen zwischen Kontaktflächen 21 der Aufnahmewangen 12, 13 und dem Lotdepot 20 ausgebildeten Körperkontakt ein Aufschmelzen des Lotdepots 20 erfolgt.

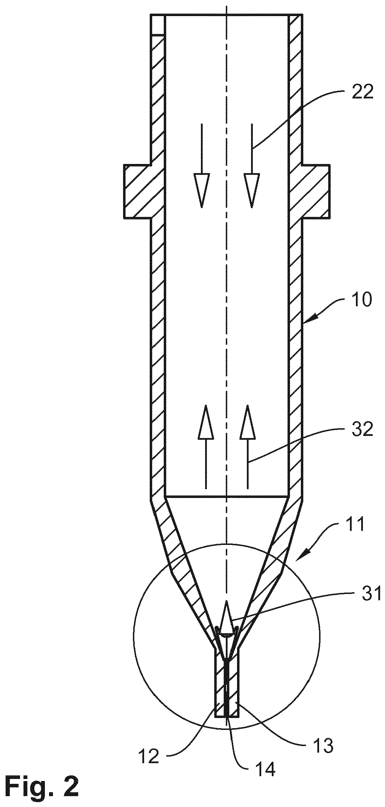

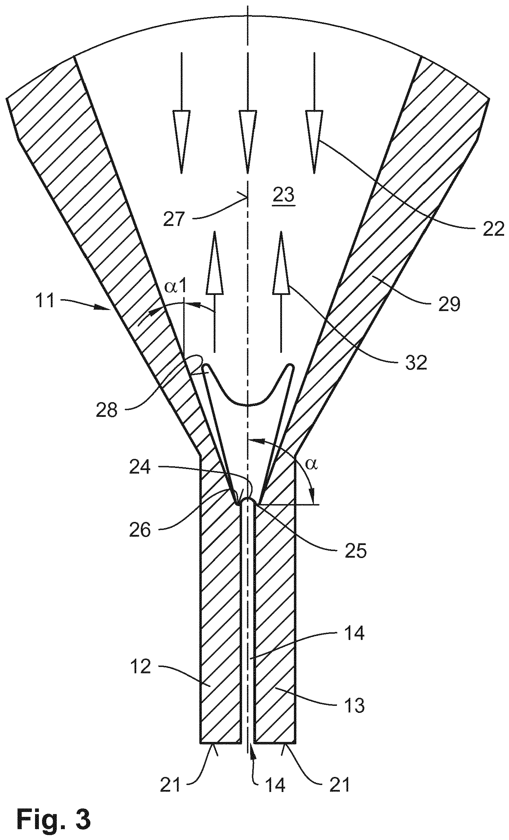

Wie aus den **Figuren 2** und **3** ersichtlich, erfolgt zum Eintrag der zum Aufschmelzen des Lotmaterialdepots 20 erforderlichen Wärmeenergie eine Beaufschlagung der Aufnahmewangen 12, 13 durch Laserenergie 22, die als Laserstrahlung durch einen im Kontaktkopf 10 ausgebildeten Transmissionskanal 23 in die Aufnahmewangen 12, 13 eingebracht wird.

Wie insbesondere **Fig. 3** zeigt, ist in einer Kanalmündung 24 im Übergang zu einem Öffnungsrand 25 des Aufnahmespalts 14 eine Absorptionsfläche 26 ausgebildet, die im vorliegenden Fall als Absatz ausgebildet ist.

Damit weist die Absorptionsfläche 26 gegenüber einer Kanalachse 27 einen Neigungswinkel α = 90° auf, der größer ist als ein Neigungswinkel al = 45°, mit dem ein an die Absorptionsfläche 26 angrenzender Wandabschnitt 28 einer Kanalwandung 29 gegenüber der Kanalachse 27 geneigt ist.

Wie **Fig. 1** zeigt, sind die Aufnahmewangen 12, 13 in ihrer Breite b so bemessen, dass die Breite einer Aufnahmewange 12, 13 kleiner ist als ein regelmäßig zwischen den Prüfkontakten 15, 16, 17 der Prüfkontaktanordnung 30 ausgebildeter Pitch p.

Wie anhand der in **Fig. 2** eingezeichneten Richtungspfeile verdeutlicht, dient der Transmissionskanal 23 nicht nur zur Beaufschlagung der Aufnahmewangen 12, 13 mit Laserenergie 22, sondern auch zur Beaufschlagung des zwischen den Aufnahmewangen 12, 13 ausgebildeten Aufnahmespalts mit Unterdruck 31 und auch zur Übertragung einer von den Aufnahmewangen 12, 13 zu einer hier nicht näher dargestellten Sensoreinrichtung übermittelten Infrarot-Reflexionsstrahlung 32, die vermittels eines entsprechenden Sensorausgangssignals eines InfrarotSensors der Sensoreinrichtung als Eingangsgröße für eine ebenfalls nicht näher dargestellte Steuereinrichtung zur Steuerung einer die Laserenergie 22 emittierenden Lasereinrichtung dient.

## Patentansprüche

1. Vorrichtung zur Platzierung und Kontaktierung eines Prüfkontakts (15) einer auf einem Kontaktträger (19) angeordneten Prüfkontaktanordnung (30), wobei die Vorrichtung einen Kontaktkopf (10) mit zumindest einem Transmissionskanal (23) zur Transmission von Wärmeenergie und Übertragung von Unterdruck aufweist, wobei der Kontaktkopf an seinem Kontaktierungsende im Bereich einer Kanalmündung (24) mit einer Prüfkontaktaufnahme (11) versehen ist,
**dadurch gekennzeichnet,**
**dass** die Prüfkontaktaufnahme einen zwischen zwei parallelen Aufnahmewangen (12, 13) zur Aufnahme des Prüfkontakts ausgebildeten und mit dem Transmissionskanal verbundenen Aufnahmespalt (14) aufweist, wobei die Aufnahmewangen an ihren zur Kontaktierung mit einem auf dem Kontaktträger angeordneten Lotdepot (20) vorgesehenen Kontaktenden Kontaktflächen (21) zur Herstellung eines wärmeleitenden Kontakts mit dem Lotmaterial des Lotdepots aufweisen.

2. Vorrichtung nach Anspruch 1,
**dadurch gekennzeichnet,**
**dass** der Transmissionskanal (23) in der Kanalmündung (24) im Übergang zu einem Öffnungsrand (25) des Aufnahmespalts (14) eine Absorptionsfläche (26) in einer Kanalwandung (29) aufweist, die einen größeren Neigungswinkel α zu einer Kanalachse (27) aufweist als ein an die Absorptionsfläche angrenzender Wandabschnitt (28) der Kanalwandung.

3. Vorrichtung nach Anspruch 2,
**dadurch gekennzeichnet,**
**dass** die Absorptionsfläche (26) durch einen Absatz in der Kanalwandung ausgebildet ist.

4. Vorrichtung nach Anspruch 2,
**dadurch gekennzeichnet,**
**dass** die Absorptionsfläche durch eine Parabolfläche ausgebildet ist.

5. Vorrichtung nach einem der vorangehenden Ansprüche,
**dadurch gekennzeichnet,**
**dass** die Aufnahmewangen (12, 13) aus einem vom Material der Kanalwandung (29) abweichenden Material gebildet sind.

6. Vorrichtung nach einem der vorangehenden Ansprüche,
**dadurch gekennzeichnet,**
**dass** die Kontaktflächen (21) der Aufnahmewangen (12, 13) ein Flächenprofil aufweisen.

7. Vorrichtung nach einem der vorangehenden Ansprüche,
**dadurch gekennzeichnet,**
**dass** die Aufnahmewangen austauschbar an der Prüfkontaktaufnahme angeordnet sind.

8. Vorrichtung nach einem der vorangehenden Ansprüche,
**dadurch gekennzeichnet,**
**dass** die Vorrichtung neben einer Anschlussvorrichtung zur Verbindung mit einer Lasereinrichtung und einer Anschlussvorrichtung zur Verbindung mit einer Unterdruckquelle eine Infrarot-Sensoreinrichtung aufweist mit einem Infrarotsensor zur Erfassung einer von den Aufnahmewangen (12, 13) reflektierten Infrarotstrahlung und mit einer Steuereinrichtung zur Steuerung der Lasereinrichtung in Abhängigkeit von einem Sensorsignal des Infrarotsensors.

## Claims

1. A device for the placing and contacting of a test contact (15) of a test contact arrangement (30) arranged on a contact carrier (19), wherein the device features a contact head (10) having at least one transmission channel (23) for transmitting thermal energy and transferring a vacuum, wherein the contact head is provided with a test contact receptacle (11) at its contact end in the area of a channel mouth (24),
**characterised in that**
the test contact receptacle has a receiving gap (14) formed between two parallel receiving cheeks (12, 13) for receiving the test contact and connected with the transmission channel, wherein the receiving cheeks have contact surfaces (21) at their contact ends for contacting a solder deposit arranged (20) on the contact carrier, in order to produce a heat conducting contact with the solder material of the solder deposit.

2. The device according to Claim 1,
**characterised in that**
the transmission channel (23), in the channel mouth (24) in the transition to an opening rim (25) of the receiving gap (14), comprises an absorption surface (26) in a channel wall (29), said absorption surface (26) having a larger angle of inclination α in relation to a channel axis (27) than a wall section (28) of the channel wall adjacent to the absorption surface.

3. The device according to Claim 2,
**characterised in that**
the absorption surface (26) is formed by a step in the channel wall.

4. The device according to Claim 2,
**characterised in that**
the absorption surface is formed by a parabolic surface.

5. The device according to any one of the preceding Claims,
**characterised in that**
the receiving cheeks (12, 13) are composed of a material different from the material of the channel wall (29).

6. The device according to any one of the preceding Claims,
**characterised in that**
the contact surfaces (21) of the receiving cheeks (12, 13) exhibit a surface profile.

7. The device according to any one of the preceding Claims,
**characterised in that**
the receiving cheeks are arranged on the test contact receptacle so as to be exchangeable.

8. The device according to any one of the preceding Claims,
**characterised in that**
besides having a connecting device for connection to a laser device and a connection device for connection to a vacuum source, the device has an infrared sensor device having an infrared sensor for detecting infrared radiation reflected by the receiving cheeks (12, 13), and having a control device for controlling the laser device subject to the sensor signal of the infrared sensor.

## Revendications

1. Dispositif de mise en place et de mise en contact d'un contact d'essai (15) d'un agencement de contacts d'essai (30) disposé sur un porte-contact (19), ledit dispositif présentant une tête de contact (10) ayant au moins un canal de transmission (23) pour la transmission d'énergie thermique et pour le transfert d'une dépression, ladite tête de contact étant pourvue d'un logement de contacts d'essai (11) à son extrémité de mise en contact dans la région d'une embouchure de canal (24),
**caractérisé en ce que**
le logement de contacts d'essai présente un entrefer de logement (14) formé entre deux limons de logement (12, 13) parallèles pour recevoir le contact d'essai et relié avec le canal de transmission, lesdits limons de logement présentant, à leurs extrémités de contact prévues pour la mise en contact avec un dépôt de brasage (20) disposé sur le porte-contact, des surfaces de contact (21) pour établir un contact conducteur de chaleur avec le matériau de brasage du dépôt de brasage.

2. Dispositif selon la revendication 1,
**caractérisé en ce que**
le canal de transmission (23), dans l'embouchure de canal (24) dans la transition vers une bordure d'ouverture (25) de l'entrefer de logement (14), présente une surface d'absorption (26) dans une paroi de canal (29), ladite surface d'absorption (26) présentant un angle d'inclinaison α par rapport à un axe de canal (27) qui est supérieur à celui d'une section de paroi (28) de la paroi de canal adjacente à la surface d'absorption.

3. Dispositif selon la revendication 2,
**caractérisé en ce que**
la surface d'absorption (26) est réalisée par un épaulement dans la paroi de canal.

4. Dispositif selon la revendication 2,
**caractérisé en ce que**
la surface d'absorption est réalisée par une surface parabolique.

5. Dispositif selon l'une quelconque des revendications précédentes, **caractérisé en ce que**
les limons de logement (12, 13) sont formés par un matériau différant du matériau de la paroi de canal (29).

6. Dispositif selon l'une quelconque des revendications précédentes, **caractérisé en ce que**
les surfaces de contact (21) des limons de logement (12, 13) présentent un profil de surface.

7. Dispositif selon l'une quelconque des revendications précédentes, **caractérisé en ce que**
les limons de logement sont disposés sur le logement de contact d'essai de manière à être interchangeable.

8. Dispositif selon l'une quelconque des revendications précédentes, **caractérisé en ce**
**qu'**en plus d'un dispositif de raccord pour le raccordement avec une unité laser et d'un dispositif de raccord pour le raccordement avec une source de dépression, le dispositif présente une unité capteur infrarouge ayant un capteur infrarouge pour enregistrer une onde infrarouge qui est reflétée par les limons de logement (12, 13), et ayant une unité de commande pour commander l'unité laser en fonction d'un signal de capteur du capteur infrarouge.
